# FASCICULE DE BREVET EUROPEEN

(11) **EP 2 906 997 B1**
(45) Date de publication et mention de la délivrance du brevet: **03.11.2021**
(21) Numéro de dépôt: 13786705.7
(22) Date de dépôt: 11.10.2013
(51) Int. Cl.: G04F 5/14

(54) **CELLULE À VAPEUR ALCALINE NOTAMMENT POUR HORLOGE ATOMIQUE ET PROCÉDÉ DE FABRICATION**
ALKALIMETALLDAMPFZELLE, INSBESONDERE FÜR EINE ATOMUHR, UND HERSTELLUNGSVERFAHREN
ALKALI-METAL VAPOUR CELL, ESPECIALLY FOR AN ATOMIC CLOCK, AND MANUFACTURING PROCESS

(30) Priorité: 12.10.2012 FR 1259783
(43) Date de publication de la demande: 19.08.2015
(73) Titulaire: Centre National de la Recherche Scientifique (C.N.R.S.), 75016 Paris (FR); Université de Franche-Comté, 25030 Besançon Cedex (FR)
(72) Inventeur: PASSILLY, Nicolas, F-25870 Auxon-Dessus (FR); GORECKI, Christophe, F-70150 Pin (FR); CHUTANI, Ravinder, F-25000 Besancon (FR); BOUDOT, Rodolphe, F-25620 Trepot (FR)
(74) Mandataire: Marks & Clerk France
(86) Numéro de dépôt international: PCT/FR2013/052432
(87) Numéro de publication internationale: WO 2014/057229

(56) Documents cités:
- CN-A- 102 323 738
- JP-A- 2007 178 274
- US-A1- 2006 022 761
- US-A1- 2007 139 128
- US-A1- 2007 146 085
- US-A1- 2010 189 605
- WENLONG WEI ET AL: "Fabrication of wafer-level spherical Rb vapor cells for miniaturized atomic clocks by a chemical foaming process", ELECTRONIC PACKAGING TECHNOLOGY AND HIGH DENSITY PACKAGING (ICEPT-HDP), 2012 13TH INTERNATIONAL CONFERENCE ON, IEEE, 13 août 2012 (2012-08-13), pages 1639-1641, XP032339069, DOI: 10.1109/ICEPT-HDP.2012.6474922 ISBN: 978-1-4673-1682-8

## Description

L'invention concerne le domaine des cellules à gaz et des horloges atomiques.

Plus précisément, l'invention concerne le domaine de telles cellules à vapeur alcaline (césium) pouvant être de petite taille, par exemple un volume de quelques cm³, dont une application typique est une horloge atomique à l'échelle d'une puce, connue sous l'acronyme CSAC (pour Chip-Scale Atomic Clock). De telles cellules et horloges atomiques sont parfois qualifiées de « microcellules » ou de « micro-horloges ». Dans l'ensemble du texte, le terme « micro » doit être compris dans le contexte et avec le sens indiqués.

De telles micro-horloges atomiques sont destinées par exemple aux systèmes de télécommunication, navigation et défense. Mais les cellules à vapeur alcaline ici considérées peuvent être également utilisées dans des capteurs tels que des micro-magnétomètres et des micro-gyromètres.

Les micro-horloges atomiques ici considérées sont celles reposant sur le principe de la résonnance atomique par piégeage cohérent de population connu sous l'acronyme CPT (pour Coherent Population Trapping).

Les recherches ont permis de proposer depuis les années 2004 quelques prototypes de CSAC, notamment dans le cadre du programme NIST (acronyme pour National Institute of Standards and Technology). Plus récemment, la société SYMMETRICOM a mis sur le marché la CSAC dénommée SA.45s, laquelle a un volume de 16 cm³, une masse de 35 g et nécessite une puissance de seulement 120mW.

Dans le cadre du consortium MAC-TFC, l'institut FEMTO-ST (acronyme pour Franche-Comté Electronique Mécanique Thermique et Optique - Sciences et Technologies) a réalisé, à partir des années 2008, des travaux en vue de concevoir et réaliser une cellule à vapeur de césium très compacte (quelques mm³), avec micro-usinage MEMS (acronyme pour MicroElectroMechanical Systems) du silicium et collage anodique. La cellule est limitée de part et d'autre par un premier couvercle en verre et un second couvercle en verre, écartés l'un de l'autre et disposés parallèlement l'un à l'autre. La cellule forme une cavité scellée sous vide dont l'emplissage avec le césium est réalisé par la mise en œuvre d'un distributeur alcalin chauffé localement, ce qui permet de pallier le problème du conflit entre le collage anodique et la chimie du césium (voir « New approach of fabrication and dispensing of micromachined césium vapor cell » de L. Nieradko, C. Gorecki, A. Douahi, V. Giordano, J.C. Beugnot, J. Dziuban et M. Moraja publié dans JOURNAL OF MICRO-NANOLITHOGRAPHY MEMS AND MOEMS d'août 2008). Cette cellule a une architecture dite « transmissive », le laser, en l'espèce un laser à cavité verticale connu sous l'acronyme VCSEL (pour Vertical Cavity Surface Emitting Laser), et le photo détecteur, (photodiode) étant situés de part et d'autre de la cellule proprement dite, le faisceau laser la traversant de part en part, y entrant par le premier couvercle en verre et en sortant par le second couvercle en verre.

L'état de la technique est aussi illustré par les documents EP 0 550 240, EP 2 154 586, EP 2 362 282, US 6 265 945, US 6 320 472, US 2002/0163394, US 2009/0251224, JP 2007 178273 et JP 2007 178274 qui décrivent différents agencements qui tous ont une architecture dans laquelle le faisceau laser traverse la cellule de part en part, comme précédemment.

Le document US 2005/0046851 vise à proposer des CSACs plus compactes, moins complexes et moins coûteuses que celles existants. Il est décrit une architecture dans laquelle le VCSEL et le photodétecteur sont intégrés de sorte à former un ensemble situé à la première extrémité de la cellule, tandis qu'une surface plane réfléchissante est prévue à la seconde extrémité de la cellule, les deux extrémités étant planes, écartées l'une de l'autre et disposées parallèlement l'un à l'autre. Avec cette architecture, le VCSEL produit un faisceau laser divergent qui traverse une première fois la cellule pour atteindre la surface plane réfléchissante, puis, après réflexion traverse une seconde fois la cellule dans le sens opposé afin d'atteindre le photo détecteur. Une telle architecture a pour inconvénient, notamment, de nécessiter un rayon laser divergent et de conduire à une double traversée de la cellule dans deux sens opposés.

Le document CN 102323738 décrit une cellule à vapeur alcaline pour horloge atomique dans laquelle le faisceau laser est injecté dans la cellule à l'aide d'un prisme réflecteur.

Il existe par conséquent le besoin de cellules à gaz (à vapeur alcaline) tout spécialement destinées à des horloges atomiques telles que des CSACs, ayant une architecture qui permet d'améliorer leurs performances en termes de compacité, stabilité de fréquence, puissance de consommation et intégration des composants de l'horloge, et ce, moyennant un processus d'assemblage à la fois plus simple, plus précis et bien adapté à une production industrielle à grande échelle.

Ci-après, un exposé de l'invention telle que caractérisée dans les revendications.

Selon un premier aspect divulgué dans la revendication indépendante 1, l'invention a pour objet une cellule à vapeur alcaline, destinée notamment à être incluse dans une horloge atomique, apte à être associée, d'une part, à un laser d'émission d'un faisceau laser extérieur entrant impactant la cellule et, d'autre part, à un photodétecteur de réception d'un faisceau laser extérieur sortant de la cellule, le faisceau laser ayant traversé la cellule, ladite cellule comprenant, d'une part, un boîtier ayant une fenêtre optique amont et une fenêtre optique aval et formant une cavité optique emplie de vapeur alcaline telle que comprenant du césium, la fenêtre optique amont (9) et la fenêtre optique aval (10) étant disposées d'un seul et même côté de la cellule (2) et, d'autre part, des moyens micro-optiques disposés dans la cavité optique et comprenant un réflecteur optique amont et un réflecteur optique aval du faisceau laser, inclinés l'un par rapport à l'autre, le réflecteur amont étant incliné par rapport au plan de la fenêtre amont et à l'axe du faisceau laser entrant, de sorte que le faisceau laser extérieur entrant traverse la fenêtre amont pour former un faisceau laser intérieur entrant, que le faisceau laser intérieur entrant soit réfléchi sur le réflecteur amont et dévié en direction du réflecteur aval pour former un faisceau laser intérieur intermédiaire, que le faisceau laser intérieur intermédiaire soit réfléchi sur le réflecteur aval et dévié en direction de la fenêtre aval pour former un faisceau laser intérieur sortant, et que le faisceau laser intérieur sortant traverse la fenêtre aval pour former le faisceau laser extérieur sortant. La cellule comprend également des moyens de diffraction amont du faisceau laser extérieur entrant, situés en amont du réflecteur amont et des moyens de diffraction aval du faisceau laser réfléchi par le réflecteur aval, situés en aval du réflecteur aval, de sorte à combiner la déviation réalisée par les moyens de diffraction avec la déviation réalisée par le réflecteur associé, lesdits moyens de diffraction amont et aval étant respectivement associés aux fenêtres amont et aval. Les réflecteurs et les moyens de diffraction sont configurés de manière à garder l'état de polarisation circulaire du faisceau laser au cours de son trajet, et le faisceau laser extérieur entrant et le faisceau laser extérieur sortant sont disposés parallèlement l'un à l'autre, les moyens de diffraction amont et aval et les réflecteurs amonts et aval étant agencés de sorte que le faisceau laser intérieur intermédiaire forme un angle de 90° avec le faisceau laser extérieur entrant et avec le faisceau laser extérieur sortant.

Selon une réalisation, le réflecteur amont et le réflecteur aval sont disposés de façon symétrique par rapport à un plan médian transversal de la cellule.

Selon une réalisation, le réflecteur amont et le réflecteur aval sont écartés l'un de l'autre, l'écartement entre eux conditionnant la dimension de la cavité optique et de la cellule dans la direction de l'axe du faisceau laser intérieur intermédiaire.

Selon les réalisations, l'écartement entre le réflecteur amont et le réflecteur aval est choisi en fonction de l'importance du signal CPT souhaité.

Selon une réalisation, l'écartement entre le réflecteur amont et le réflecteur aval est compris entre de l'ordre de 3 mm et de l'ordre de 9 mm, plus spécialement entre de l'ordre de 4 mm et de l'ordre de 8 mm, plus spécialement encore entre de l'ordre de 5 mm et de l'ordre de 7 mm.

Selon une réalisation, la fenêtre optique amont et la fenêtre optique aval sont formées par deux portions écartées l'une de l'autre d'une seule et même plaquette - ou wafer - en verre.

Selon une réalisation, la cellule à vapeur alcaline comprend un seul et même côté d'association avec le laser d'émission du faisceau laser entrant et avec le photodétecteur de réception du faisceau laser sortant.

Selon une réalisation, la cellule à vapeur alcaline comporte, en outre, dans la cavité optique, un ou des masques empêchant le passage du faisceau laser dans la ou les régions non souhaitées.

Selon une réalisation, le réflecteur amont et le réflecteur aval sont formés par conformation, en particulier gravure, d'une plaquette - ou wafer -, et comportent un revêtement de réflexion, en particulier métallique, plus spécialement en aluminium.

Selon une réalisation, la cellule à vapeur alcaline comprend, outre la cavité optique, une cavité de dispenseur, adjacente à et en communication avec la cavité optique, apte à recevoir un dispenseur de métal alcalin, tel que le césium, la vapeur alcaline qui est générée par chauffage après scellement étanche de la cellule migrant vers et dans la cavité optique par la communication entre les deux cavités.

Selon une réalisation, la cavité optique est emplie de vapeur alcaline et d'un gaz tampon.

Selon une réalisation, à la cellule à vapeur alcaline sont associés des moyens optiques de mise en forme du faisceau laser extérieur entrant, en particulier une lame quart d'onde et une lentille de collimation.

Selon une réalisation, le boîtier comprend, d'une part, une plaquette - ou wafer - conformable, conformée en creux de sorte à former le creux de la cavité optique, le réflecteur amont, le réflecteur aval, le cas échéant le creux de la cavité de dispenseur et le dégagement de la communication entre les deux cavités et, d'autre part, une plaquette - ou wafer - en verre de sorte à former la fenêtre optique amont et la fenêtre optique aval et à fermer la cavité optique, le cas échéant la cavité de dispenseur, et à laquelle sont associés, le cas échéant, des moyens de diffraction, la plaquette - ou wafer - en verre et la plaquette - ou wafer - conformée en creux étant disposées en regard l'une de l'autre et scellées l'une à l'autre, en particulier par soudure anodique.

Selon une réalisation, la cellule à vapeur alcaline comporte une plaquette - ou wafer - conformable, gravée en creux et le réflecteur amont et le réflecteur aval sont gravés selon les plans cristallins du matériau constitutif de la plaquette - ou wafer - conformable.

Selon une réalisation, la cellule à vapeur alcaline comprend une plaquette - ou wafer - de silicium, conformable, gravée avec une forme pyramidale selon les plans cristallins [111] à 54,7° de sorte à former le réflecteur amont, le réflecteur aval et le creux de la cavité optique et, en combinaison, des moyens de diffraction amont en direction du bord extérieur adjacent de la cellule et le cas échéant des moyens de diffraction aval avec un angle de 19,48°.

Selon un deuxième aspect divulgué dans la revendication indépendante 15, l'invention a pour objet un procédé de fabrication d'une cellule à vapeur alcaline telle qu'elle a été dernièrement décrite, dans lequel :
- on dispose d'une plaquette - ou wafer - conformable et on la conforme en creux, en particulier on la grave, de sorte à former le creux de la cavité optique, le réflecteur amont, le réflecteur aval, le cas échéant le creux de la cavité de dispenseur et le dégagement de la communication entre les deux cavités,
- on dispose d'une plaquette - ou wafer - en verre apte à former la fenêtre optique amont et la fenêtre optique aval et à fermer la cavité optique, le cas échéant la cavité de dispenseur,
- d'une part, on dispose l'une en regard de l'autre et on scelle l'une à l'autre, en particulier par soudure anodique, la plaquette - ou wafer - conformée en creux et la plaquette - ou wafer - en verre,
- d'autre part, on emplit la cavité optique de vapeur alcaline,
- et, le cas échéant, on associe à la plaquette - ou wafer - en verre des moyens de déviation, en particulier de diffraction.

Selon une réalisation du procédé de fabrication d'une cellule à vapeur alcaline en question :
- d'une part, on dispose d'une plaquette - ou wafer - de silicium, gravable, et on la grave avec une forme pyramidale selon les plans cristallins [111] à 54,7° par gravure humide de sorte à former le réflecteur amont, le réflecteur aval et le creux de la cavité optique,
- d'autre part, on associe à la plaquette - ou wafer - en verre des moyens de diffraction.

Selon une réalisation du procédé de fabrication d'une cellule à vapeur alcaline en question on forme une cavité de dispenseur, adjacente à et en communication avec la cavité optique, on place un dispenseur de métal alcalin, tel que le césium, dans la cavité de dispenseur et, une fois que la plaquette - ou wafer - conformée en creux et la plaquette - ou wafer - en verre sont scellées l'une à l'autre, on assure un chauffage tel qu'est générée de la vapeur alcaline qui migre vers et dans la cavité optique par la communication entre les deux cavités.

Selon différentes réalisations du procédé de fabrication d'une cellule à vapeur alcaline en question, ce procédé comprend l'une au moins des opérations suivantes :
- mise en place d'un ou plusieurs masques dans la cavité optique en vue d'empêcher le passage du faisceau laser dans la ou les régions non souhaitées,
- mise en place sur le réflecteur amont et le réflecteur aval d'un revêtement de réflexion, en particulier métallique, plus spécialement en aluminium,
- introduction dans la cavité optique d'un gaz tampon,
- association à la cellule à vapeur alcaline de moyens optiques de mise en forme du faisceau laser extérieur entrant, en particulier une lame quart d'onde et une lentille de collimation.

Selon un troisième aspect, l'invention a pour objet une horloge atomique comprenant une cellule à vapeur alcaline telle qu'elle a été précédemment décrite, associée, de façon compacte, d'une part, à un laser d'émission d'un faisceau laser extérieur entrant impactant la cellule et, d'autre part, à un photodétecteur de réception d'un faisceau laser extérieur sortant de la cellule.

Selon une réalisation, le laser d'émission du faisceau laser entrant et le photodétecteur de réception du faisceau laser sortant sont associés à la cellule sur un seul et même côté d'association de celle-ci.

Selon une réalisation le faisceau laser entrant et le faisceau laser sortant sont disposés parallèlement l'un à l'autre, l'un à côté de l'autre.

Selon une réalisation, le laser est un laser à cavité verticale VCSEL.

Par rapport à l'état de la technique antérieure, les avantages de l'invention sont, s'agissant des cellules à gaz à vapeur alcaline (césium) et des systèmes qui les incorporent, tels que des horloges atomiques (CSACs), l'amélioration des performances en termes de compacité, stabilité de fréquence, puissance de consommation et intégration des composants moyennant un processus d'assemblage à la fois plus simple, plus précis et bien adapté à une production industrielle à grande échelle.

On décrit maintenant brièvement les figures des dessins.

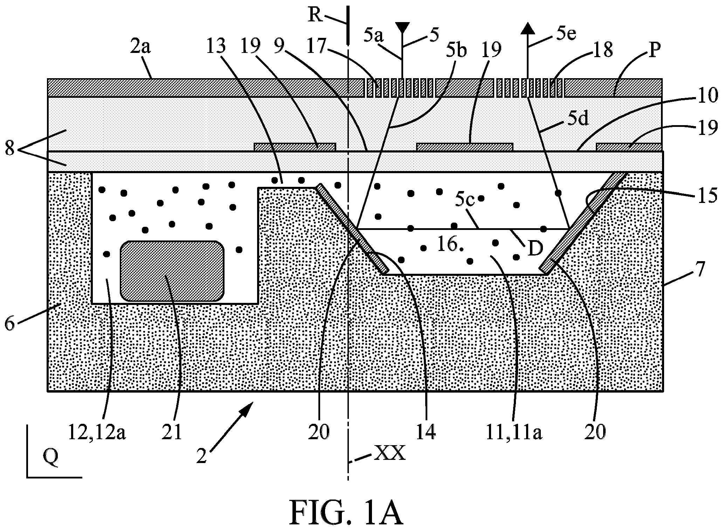

La figure 1A est un schéma correspondant à une coupe transversale destinée seulement à expliquer les principes d'une cellule à gaz à vapeur alcaline (césium) selon l'invention dans le cas où elle comporte une cavité de dispenseur, alors que le laser et le photodétecteur destinés à être associés à la cellule ne sont pas représentés, pas plus que le faisceau laser qui, en fonctionnement, traverse la cellule, le, schéma illustrant notamment la fenêtre optique amont, la fenêtre optique aval, la cavité optique emplie de vapeur alcaline, le réflecteur optique amont et le réflecteur optique aval ayant un revêtement de réflexion, la fenêtre optique amont et la fenêtre optique aval étant disposées d'un seul et même côté de la cellule, des moyens de diffraction étant associés à la fenêtre optique amont et à la fenêtre optique aval. Dans ce schéma de principe, la cavité de dispenseur est disposée (de façon volontairement artificielle) dans le prolongement de la longueur de la cavité optique, de façon à pouvoir montrer sur un seul et même schéma la cavité de dispenseur, la cavité optique et la déviation du faisceau laser.

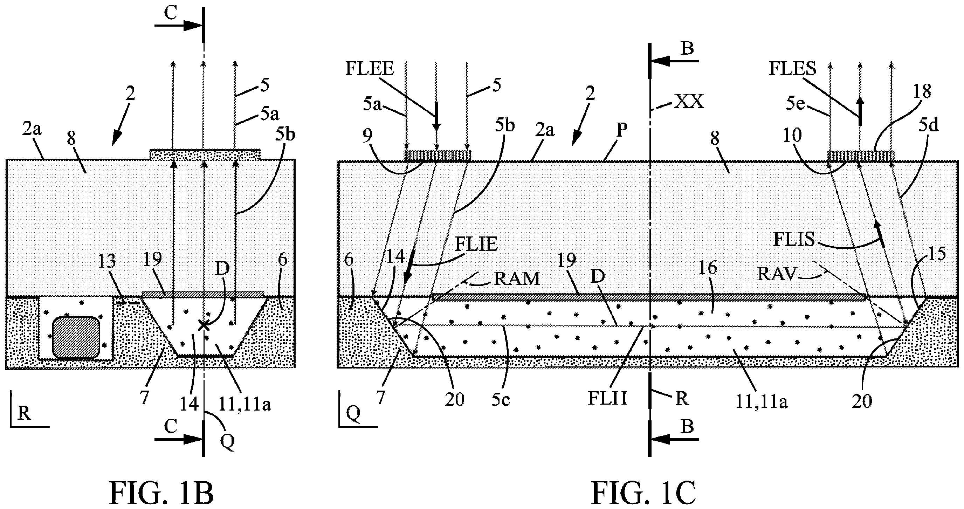

Les figures 1B et 1C sont deux vues en coupe selon deux plans perpendiculaires illustrant une réalisation matérielle possible de cellule avec cavité de dispenseur, le réflecteur optique amont et le réflecteur optique aval étant formés par gravure, d'une plaquette - ou wafer - et disposés de façon symétrique, à savoir, s'agissant de la figure 1B, une vue en coupe selon la ligne BB de la figure 1C et, s'agissant de la figure 1C, une coupe selon la ligne CC de la figure 1B. Dans ces figures illustrant une réalisation matérielle, la cavité de dispenseur est disposée dans le prolongement de la largeur de la cavité optique.

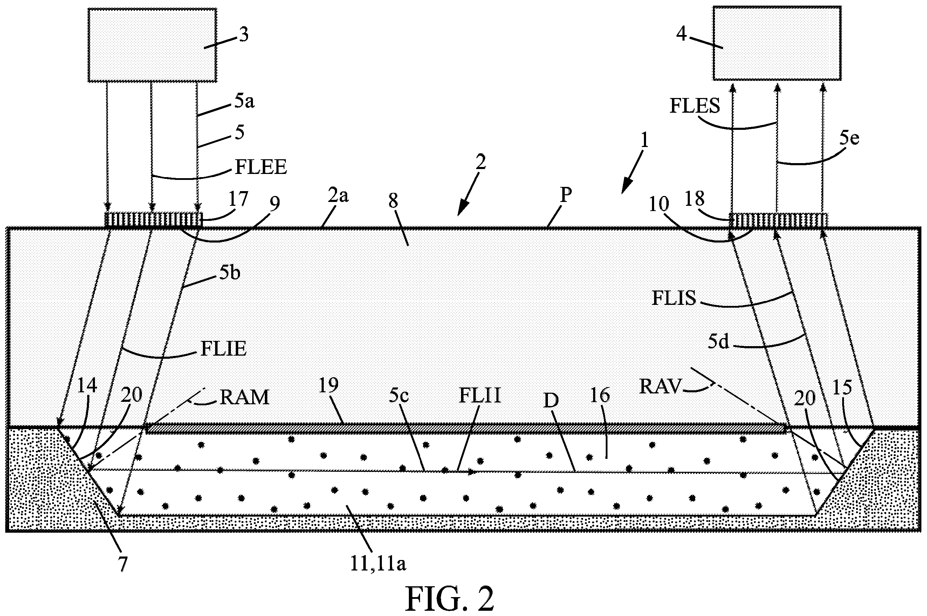

La figure 2 est un schéma d'ensemble en coupe transversale illustrant une horloge atomique CSAC selon l'invention, incluant une cellule à gaz à vapeur alcaline (césium) selon l'invention, un laser et un photodétecteur associés à la cellule et le cheminement du faisceau laser qui, en fonctionnement, traverse la cellule.

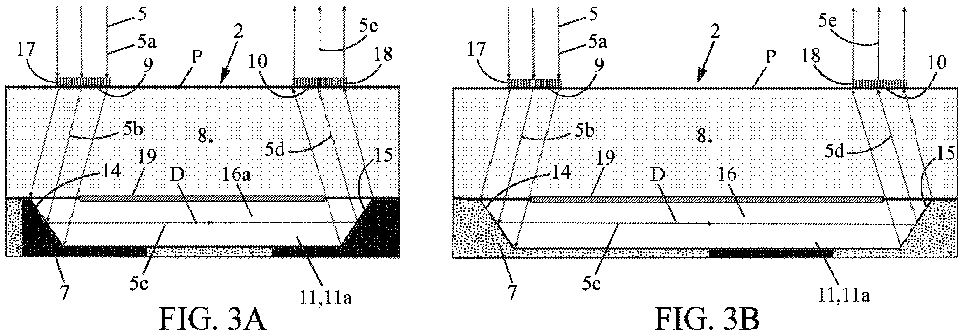

Les figures 3A et 3B illustrent de façon purement schématique le réflecteur optique amont et le réflecteur optique aval et l'écartement entre eux, ainsi que le faisceau laser, de sorte à montrer la possibilité de faire varier l'écartement entre les réflecteurs amont et aval en fonction de l'importance du signal CPT souhaité.

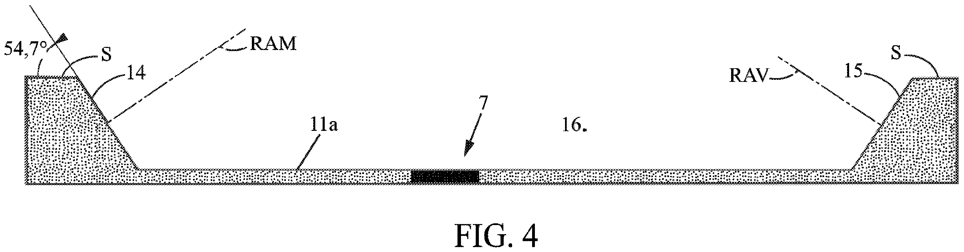

La figure 4 est un schéma en coupe transversale illustrant une plaquette - ou wafer - conformée en creux de sorte à former le creux de la cavité optique, le réflecteur amont et le réflecteur aval.

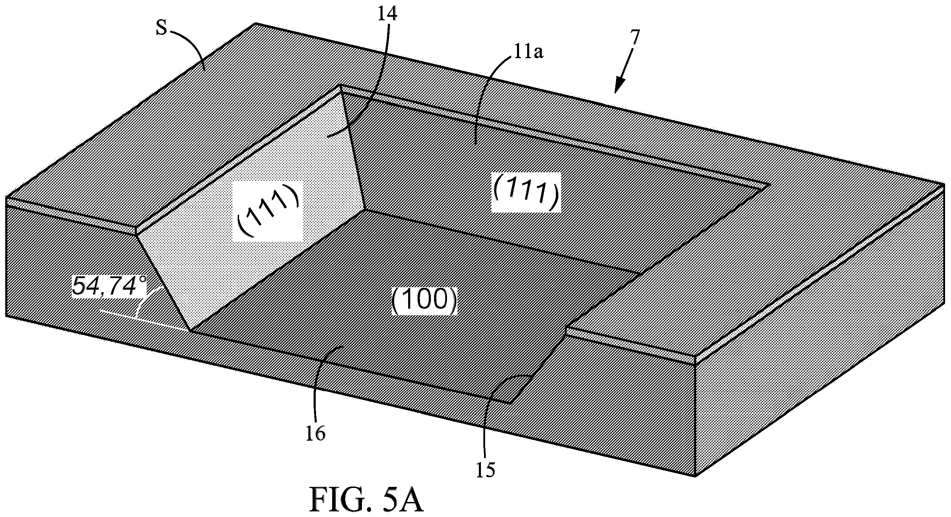

La figure 5A est un schéma en perspective de la plaquette - ou wafer - de la figure 4, illustrant la gravure en creux de forme pyramidale selon les plans cristallins [111].

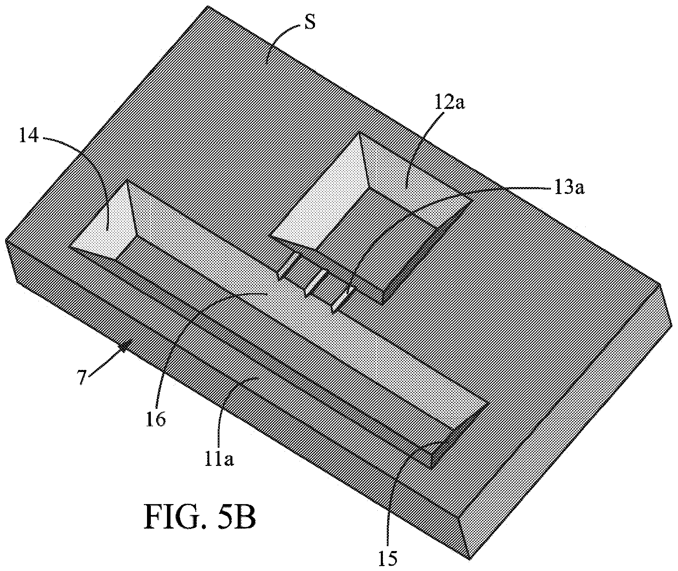

La figure 5B est un schéma en perspective de la plaquette - ou wafer - de la figure 4, illustrant la gravure en creux de la cavité optique, de la cavité de dispenseur et du dégagement de communication.

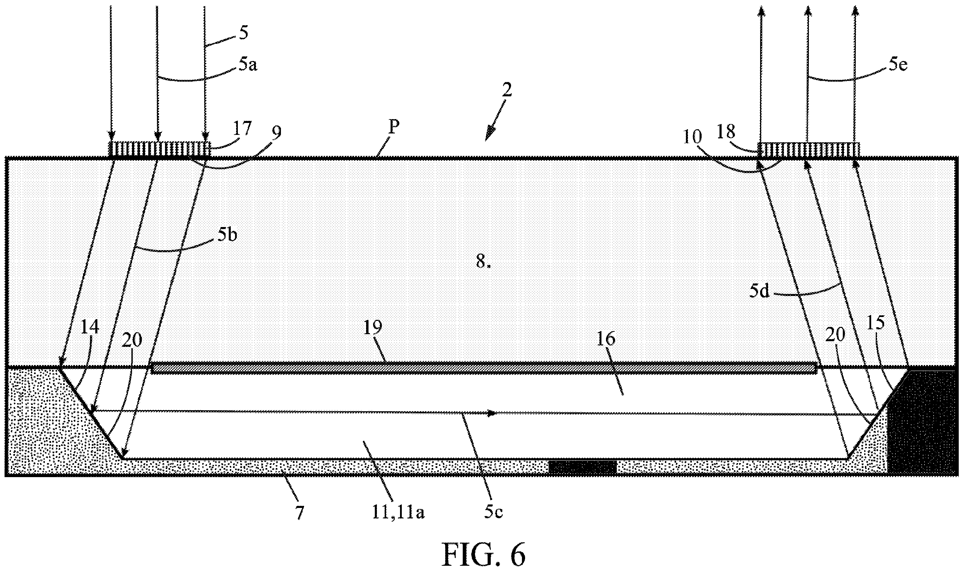

La figure 6 est un schéma en coupe transversale illustrant, avec le faisceau laser, le réflecteur optique amont et le réflecteur optique aval combinés à des moyens de diffraction amont du faisceau laser entrant, situés en amont du réflecteur amont et des moyens de diffraction aval du faisceau laser réfléchi par le réflecteur aval, situés en aval du réflecteur aval, de sorte à combiner la déviation réalisée par les moyens de diffraction avec la déviation réalisée par le réflecteur associé.

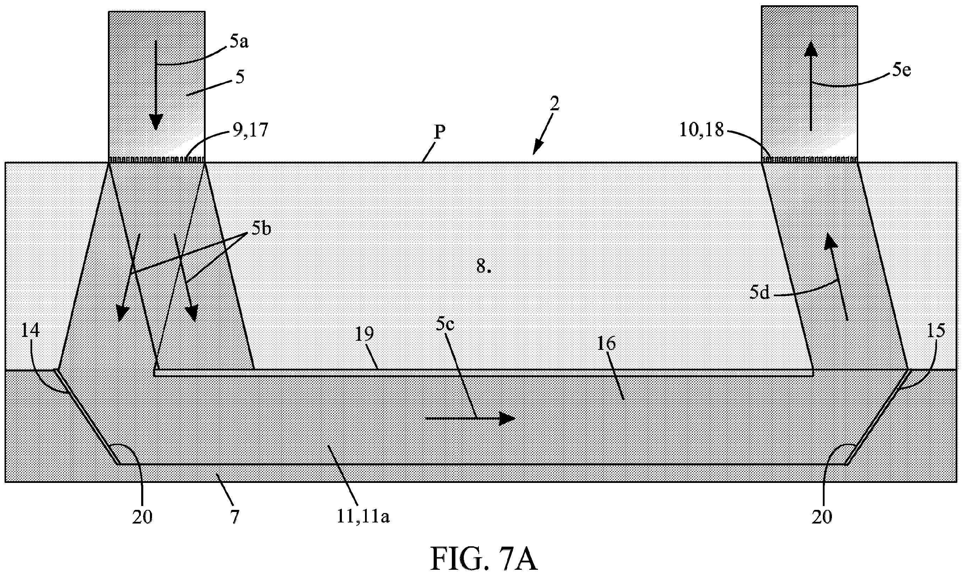

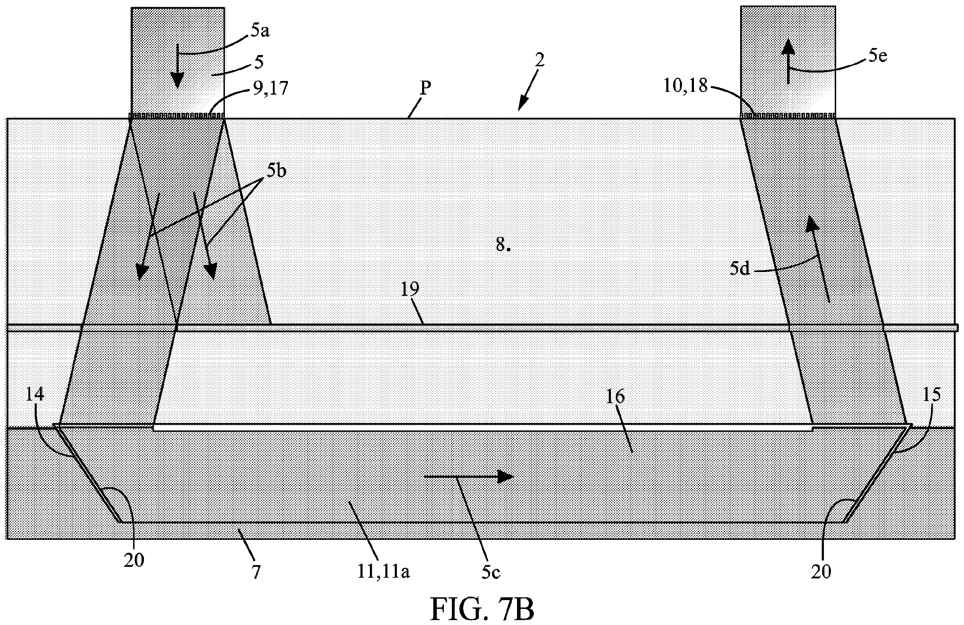

Les figures 7A et 7B sont deux schémas analogues, en coupe transversale, illustrant, avec le faisceau laser, le réflecteur optique amont et le réflecteur optique aval combinés à des masques empêchant le passage du faisceau laser dans la ou les régions non souhaitées.

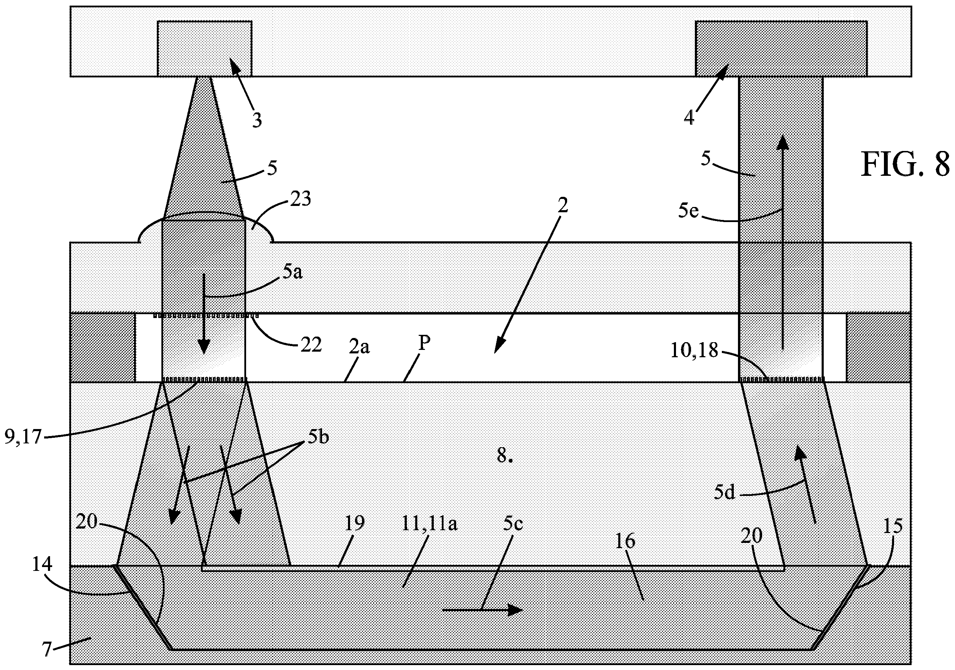

La figure 8 est un schéma en coupe transversale illustrant, avec le faisceau laser, la plaquette - ou wafer - en verre de la cellule avec des moyens de diffraction amont et des moyens de diffraction aval, et des moyens optiques de mise en forme du faisceau laser extérieur entrant, à savoir une lame quart d'onde et une lentille de collimation.

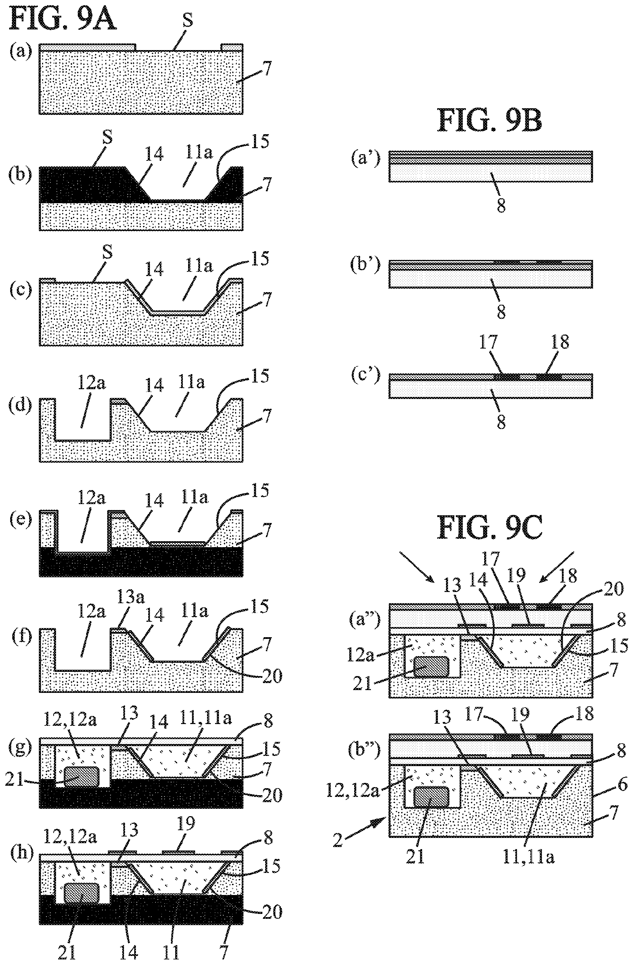

Les figures 9A, 9B et 9C illustrent les étapes successives d'un procédé de réalisation d'une cellule telle que celle représentée sur la figure 1A ; la figure 9A illustre plus spécialement la réalisation de la cellule proprement dite, la figure 9B celle du réseau de diffraction et la figure 9C leur assemblage.

Ci-après un exposé détaillé de plusieurs modes de réalisation de l'invention assorti d'exemples et de référence aux dessins.

Une horloge atomique 1 à l'échelle d'une puce (CSAC pour Chip-Scale Atomic Clock) reposant sur le principe de la résonnance atomique par piégeage cohérent de population (CPT pour Coherent Population Trapping) est représentée schématiquement sur la figure 2 et comprend une cellule à vapeur alcaline (césium) 2 à laquelle sont associés, d'une part, à un laser 3 d'émission d'un faisceau laser extérieur entrant impactant la cellule 2, ici un laser à cavité verticale (VCSEL pour Vertical Cavity Surface Emitting Laser) et un photodétecteur de réception 4 du faisceau laser extérieur sortant de la cellule 2. On désigne par 5, le faisceau laser.

Comme indiqué, le schéma de la figure 1A permet d'expliquer les principes de la cellule 2, tandis que les figures 1B et 1C représentent une telle cellule 2 selon une réalisation possible.

La cellule 2 comprend d'une part un boîtier 6. Ce boîtier 6 inclut, en premier lieu, une plaquette - ou wafer - 7, dénommée « plaquette - ou wafer - 7 conformable » ou bien « plaquette - ou wafer - 7 conformée en creux», selon qu'on la considère à l'état originel non conformé ou à l'état conformé, étant donné qu'elle est *in fine* conformée en creux comme il est exposé. Ce boîtier 6 inclut, en second lieu, une plaquette - ou wafer - en verre 8 qui est formée d'une seule plaquette ou de plusieurs plaquettes superposées.

La plaquette - ou wafer - conformée en creux 7 et la plaquette - ou wafer - en verre 8 sont disposées en regard l'une de l'autre, l'une contre l'autre.

Elles sont scellées l'une à l'autre, de façon fixe et étanche, en particulier par soudure anodique.

Le boîtier 6 (et donc par extension la cellule 2) peut avoir une forme extérieure parallélépipédique ou cylindrique ou une autre forme. Il est généralement aplati et compact moyennant un volume qui peut être de l'ordre du cm³ ou de quelques cm³. Il présente un axe XX, et deux plans transversaux perpendiculaires, à savoir un premier plan transversal Q qui est le plan de la figure 1C (et le plan médian de la cavité optique 11) et un second plan médian transversal R qui est le plan de la figure 1B.

La cellule 2 comporte ainsi une fenêtre optique amont 9 et une fenêtre optique aval 10 disposées d'un seul et même côté de la cellule 2 et formées par deux portions écartées l'une de l'autre de la plaquette - ou wafer - en verre 8.

Par ailleurs, la cellule 2 forme une cavité optique 11 qui est emplie de vapeur alcaline telle que comprenant du césium et, le cas échéant d'un gaz tampon.

Selon une possibilité illustrée sur le schéma de principe de la figure 1A et par la réalisation matérielle des figures 1B et 1C, la cellule 2 comprend, outre la cavité optique 11, une cavité de dispenseur 12, adjacente à et en communication avec la cavité optique 1 par une communication 13. Comme indiqué, à des fins purement explicatives des principes de la cellule 2, la cavité de dispenseur 12 est, sur le schéma de la figure 1A, représentée disposée dans le prolongement de la longueur de la cavité optique 11. Mais dans la réalisation matérielle de la cellule 2 telle qu'illustrée par les figures 1B et 1C, la cavité de dispenseur 12 est en fait disposée dans le prolongement de la largeur de la cavité optique 11.

Ainsi, comme illustré par les figures 5A et 5B et par les schémas (b), (d) et (e), notamment, de la figure 9A, la plaquette - ou wafer - 7 conformée en creux comporte un creux 11a pour la cavité optique 11 et, dans la réalisation représentée, un creux 12a pour la cavité de dispenseur 12. Elle comporte également un dégagement 13a pour la communication 13. Le creux 11a, l'éventuel creux 12a et le dégagement 13a se comprennent relativement à un plan de base frontal S la plaquette - ou wafer - 7, sur lequel est appliquée la plaquette - ou wafer - en verre 8.

La cellule 2 comprend d'autre part des moyens micro-optiques disposés dans la cavité optique 11.

Ces moyens micro-optiques incluent un réflecteur optique amont 14 et un réflecteur optique aval 15.

Ces deux réflecteurs optiques 14 et 15 sont plans.

Ils sont associés au faisceau laser 5 qu'ils dévient.

Les qualificatifs « amont » et « aval » se réfèrent au sens de la lumière du faisceau laser.

Les deux réflecteurs optiques 14 et 15, d'axes RAM et RAV perpendiculaires à leurs plans, respectivement, sont inclinés l'un par rapport à l'autre, et cela doit être compris comme signifiant que les axes RAM et RAV des réflecteurs optiques 14 et 15 sont inclinés l'un par rapport à l'autre.

Dans la réalisation représentée, l'angle d'ouverture entre les deux axes RAM et RAV est de 70,5°.

Le réflecteur optique amont 14 est incliné tout à la fois par rapport au plan P de la fenêtre optique amont 9 (et donc de la plaquette - ou wafer - en verre 8) et à l'axe FLIE du faisceau laser intérieur entrant 5 dans la cellule 2.

Le faisceau laser, identifié dans son ensemble par la référence 5, comporte plusieurs tronçons successifs d'amont en aval entre le laser 3 et le photodétecteur 4. Ces tronçons sont les suivants :
- (tronçon de) faisceau laser extérieur entrant 5a entre le laser 3 et la fenêtre amont 9, d'axe FLEE,
- (tronçon de) faisceau laser intérieur entrant 5b entre la fenêtre amont 9 et le réflecteur amont 14, d'axe FLIE,
- (tronçon de) faisceau laser intérieur intermédiaire 5c entre le réflecteur amont 14 et le réflecteur aval 15, d'axe FLII,
- (tronçon de) faisceau laser intérieur sortant 5d entre le réflecteur aval 15 et la fenêtre aval 10, d'axe FLIS,
- (tronçon de) faisceau laser extérieur sortant 5e entre la fenêtre aval 10 et le photodétecteur 4, d'axe FLES.

Dans le texte, au lieu de l'expression « tronçon de faisceau laser », on utilise l'expression « faisceau laser », pour des raisons de facilité de lecture.

Le réflecteur optique amont 14 et le réflecteur optique aval 15 sont inclinés l'un par rapport à l'autre, le réflecteur amont 14 est incliné par rapport au plan P de la fenêtre amont 9 et à l'axe FLIE du faisceau laser intérieur entrant 5b, le réflecteur aval 15est incliné par rapport au plan P de la fenêtre aval 10, de sorte que :
- le faisceau laser intérieur entrant 5b soit réfléchi sur le réflecteur amont 14 et dévié en direction du réflecteur aval 15,
- le faisceau laser intérieur intermédiaire 5c soit réfléchi sur le réflecteur aval 15 et dévié en direction de la fenêtre aval 10,
- le faisceau laser intérieur sortant 5d traverse la fenêtre aval 10.

Ainsi, c'est le cheminement souhaité du faisceau laser 5 et les positions relatives de ses tronçons constitutifs qui déterminent la position relative des réflecteurs optiques 14 et 15 entre eux et par rapport aux fenêtres optiques 9 et 10.

Dans la réalisation représentée, le réflecteur amont et le réflecteur aval sont disposés de façon symétrique par rapport au second plan médian transversal R de la cellule 2, c'est-à-dire que leurs axes RAM et RAV sont eux-aussi symétriques par rapport à ce plan.

Dans la réalisation représentée, le réflecteur amont et le réflecteur aval sont disposés de sorte que le faisceau laser extérieur entrant 5a ou le faisceau laser intérieur entrant 5b, d'une part, le faisceau laser extérieur sortant 5e ou le faisceau laser intérieur sortant 5d, forment un angle de 90° avec le faisceau laser intérieur intermédiaire 5c.

De surcroît, dans la réalisation représentée, le réflecteur amont 14 et le réflecteur aval 15 sont disposés de sorte que le faisceau laser extérieur entrant 5a et le faisceau laser extérieur sortant 5e sont disposés parallèlement l'un à l'autre. Ainsi, l'horloge atomique 1 est telle que le faisceau laser extérieur entrant 5a et le faisceau laser extérieur sortant 5e sont disposés parallèlement l'un à l'autre, l'un à côté de l'autre, avec un écartement qui correspond à l'écartement 16 entre le réflecteur amont 14 et le réflecteur aval 15.

Il est entendu que l'angle d'un faisceau laser 5 par rapport à un autre, comme leur parallélisme, doit être compris comme l'angle ou le parallélisme des axes des tronçons de faisceau laser.

Avec l'architecture de la cellule 2 décrite, le réflecteur amont 14 et le réflecteur aval 15 sont écartés l'un de l'autre, dans la cavité optique 11, par l'écartement 16 de direction D qui est parallèle à l'axe FLII du faisceau laser intérieur intermédiaire 5c

Cet écartement 16 est choisi en fonction de l'importance du signal CPT souhaité.

Selon les besoins et dans des réalisations possibles, l'écartement 16 est compris entre de l'ordre de 3 mm et de l'ordre de 9 mm. Plus spécialement, il peut être compris entre de l'ordre de 4 mm et de l'ordre de 8 mm. Plus spécialement encore, il peut être compris encore entre de l'ordre de 5 mm et de l'ordre de 7 mm.

Avec l'architecture décrite, la cellule 2 comprend un seul et même côté 2ad'association avec le laser 3 et avec le photodétecteur 4, à savoir le côté de la plaquette - ou wafer - en verre 8, ou bien l'opposé du côté où se trouve la plaquette - ou wafer - 7 conformée en creux. Ainsi, l'horloge atomique 1 est telle que le laser 3 d'émission du faisceau laser extérieur entrant 5, 5a et le photodétecteur de réception du faisceau laser extérieur sortant 5e sont associés à la cellule sur un seul et même côté d'association 2a de celle-ci à savoir le côté de la plaquette - ou wafer - en verre 8, ou bien l'opposé du côté où se trouve la plaquette - ou wafer - 7 conformée en creux.

Dans une réalisation représentée sur les figures (voir notamment les figures 4, 5A et 5B et les schémas (b), (c) et (d) de la figure 9A), la plaquette - ou wafer - conformable 7 est gravée en creux de sorte à former le creux 11a de la cavité optique 11, le réflecteur amont 14, le réflecteur aval 15, le cas échéant le creux 12a de la cavité de dispenseur 12 et un dégagement 13a apte à former la communication 13 entre les deux cavités 11 et 12.

Plus spécialement, le réflecteur amont 14 et le réflecteur aval 15 sont gravés selon des plans cristallins choisis du matériau constitutif de la plaquette - ou wafer - conformable 7.

Dans le cas d'une plaquette - ou wafer - 7 de silicium, celle-ci peut être gravée, à partir de son plan de base frontal S, avec une forme pyramidale, comme représenté sur la figure 5, selon les plans cristallins [111]. Ces plans cristallins sont inclinés à 54,7°, par rapport au plan S. C'est ainsi que l'on forme le réflecteur amont 14 et le réflecteur aval 15 ayant l'inclinaison des plans cristallins [111].

Avec une telle réalisation, les réflecteurs amont 14 et aval 15, ou leurs plans, ne sont pas inclinés à 45° par rapport au plan S et à 90° l'un par rapport à l'autre, de sorte qu'en l'état le cheminement du faisceau laser 5 ne pourrait être celui décrit.

C'est pourquoi, avec cette réalisation, il est prévu, comme représenté sur les figures, et tout spécialement sur la figure 6, que la cellule 2 comprenne également des moyens de diffraction amont 17 du faisceau laser extérieur entrant 5a, situés en amont du réflecteur amont 14.

Par raison de symétrie, il est également prévu, comme également représenté sur les figures, et tout spécialement sur la figure 6, ainsi que sur les schémas (b') et (b") de la figure 9B, que la cellule 2 comprenne des moyens de diffraction aval 18 du faisceau laser intérieur sortant 5d, situés en aval du réflecteur aval 15.

Avec cet arrangement, on combine la déviation réalisée par les moyens de diffraction 17 et 18 avec la déviation réalisée par le réflecteur associé 14 et 15, respectivement.

Les moyens de diffraction 17, 18 sont des moyens associés à la fenêtre optique amont, aval 9, 10.

Ces réseaux de diffraction sont déterminés en fonction de la géométrie du faisceau laser 5 qui dépend de celle des réflecteurs 14 et 15.

Ainsi, dans le cas d'une cellule 2 comprenant une plaquette - ou wafer - 7 de silicium gravée selon les plans cristallins [111] à 54,7°, il est prévu des moyens de diffraction amont 17 en direction du bord extérieur adjacent de la cellule 2 avec un angle de 19,48°. Et comme indiqué, par raison de symétrie, il est également prévu, des moyens de diffraction aval 18 en direction du bord extérieur adjacent de la cellule 2 avec un angle de 19,48°

En outre, les réflecteurs 14 et 15, et le cas échéant les moyens de diffraction 17 et 18, sont choisis de sorte à garder l'état de polarisation circulaire du faisceau laser 5 au cours de son trajet.

Selon des réalisations, comme représenté sur les figures 7A et 7B et sur le schéma (h) de la figure 9A, il est prévu que la cellule 2 comporte, également, dans la cavité optique 11, un ou des masques 19 empêchant le passage du faisceau laser 5 dans la ou les régions non souhaitées. Selon les réalisations, de tels masques 19 sont situés au même niveau que celui des réflecteurs 14 et 15 (figure 7A) ou bien sont écartés d'eux en direction axiale XX (figure 7B).

Selon des réalisations, comme représenté sur les figures 1A et 2 et sur le schéma (f) de la figure 9A, il est prévu que le réflecteur amont 14 et le réflecteur aval 15 comportent un revêtement de réflexion 20, en particulier métallique et plus spécialement en aluminium, cette réalisation n'étant toutefois pas exclusive d'autres.

Comme indiqué, la plaquette - ou wafer - 7 conformée en creux peut, selon une possibilité illustrée sur le schéma de principe de la figure 1A, par la réalisation matérielle des figures 1B et 1C et les schémas (d), (e) et (f) de la figure 9A, comporter un creux 12a de sorte que la cellule 2 comporte une cavité de dispenseur 12. Cette cavité de dispenseur 12 est apte à recevoir, et reçoit, un dispenseur 21 de métal alcalin, tel que le césium (voir schéma (g) de la figure 9A). Comme illustré par les figures 1B et 5B, la cavité de dispenseur 12 est disposée dans le prolongement de la largeur de la cavité optique 11, c'est-à-dire qu'elle s'étend parallèlement à la direction D, notamment dans la partie médiane de la longueur de la cellule 2 et du boîtier 6, comptée selon la direction D, en étant écartée des réflecteurs optiques 14 et 15.

Avec cet agencement, la vapeur alcaline qui est générée par chauffage après scellement étanche de la cellule 2, migre vers et dans la cavité optique 11 par la communication 13 entre les deux cavités 12 et 11.

Comme illustré par la figure 5B, la communication 13 est située dans la partie médiane de la longueur de la cellule 2 et du boîtier 6, comptée selon la direction D, en étant écartée des réflecteurs optiques 14 et 15. A cet égard, le schéma de principe la figure 1A montre artificiellement la communication 13 voisine du réflecteur optique amont 14, alors que dans la réalisation matérielle illustrée des figures 1B et 1C, la communication 13 est bien située dans la partie médiane de la longueur de la cellule 2 et du boîtier 6, comptée selon la direction D, en étant écartée des réflecteurs optiques 14 et 15, comme la cavité de dispenseur 12.

Une telle conception de cellule avec dispenseur reçu dans une cavité dispenseur est connue en soi de l'état de la technique connu et à la portée de l'homme du métier.

Il est entendu que l'invention n'est pas limitée à ce mode d'emplissage de la cavité optique 11.

Selon une réalisation, comme représenté sur la figure 8, il est prévu qu'à la cellule 2 soient associés des moyens optiques de mise en forme du faisceau laser extérieur entrant 5a, en particulier une lame quart d'onde 22 et une lentille de collimation 23.

L'invention a pour objet la cellule 2 ainsi décrite, l'horloge atomique 1 qui inclut cette cellule 2, mais également le procédé de fabrication d'une telle cellule 2.

Ce procédé, qui n'est pas exclusif d'autres, est illustré par les figures 9A, 9B et 9C.

Comme il est illustré par les schémas successifs (a) à (f) de la figure 9A, illustrant les étapes successives du procédé, on dispose au départ d'une plaquette - ou wafer - conformable 7 et on la conforme en creux, en particulier on la grave, de sorte à former le creux 11a de la cavité optique 11, le réflecteur amont 14, le réflecteur aval 15, le cas échéant le creux 12a de la cavité de dispenseur 12 et le dégagement 13a de la communication 13 entre les deux cavités 11, 12. Le cas échéant, le creux 12a de la cavité de dispenseur 12 et le dégagement 13a peuvent être réalisés par gravure sèche, différemment de la réalisation du creux 11a de la cavité optique 11.

Selon les réalisations, le procédé comprend également la mise en place d'un ou plusieurs masques 19 dans la cavité optique 11 et la mise en place sur le réflecteur amont 14 et le réflecteur aval 15 d'un revêtement de réflexion 20.

Selon les réalisations, le procédé comprend également les étapes de dépôt du dispenseur 21 dans le creux 12a.

D'autre part, on dispose d'une plaquette - ou wafer - en verre 8 et avec elle, on ferme le creux de la cavité optique 11a et le creux de la cavité de dispenseur 12a pour former la cavité optique 11 et la cavité de dispenseur 12 (voir schéma (g) de la figure 9A).

A cet effet, on dispose l'une en regard de l'autre et on scelle l'une à l'autre, en particulier par soudure anodique, la plaquette - ou wafer - conformée en creux 7 et la plaquette - ou wafer - en verre 8.

Par ailleurs, on emplit la cavité optique de vapeur alcaline et le cas échéant de gaz tampon selon le processus choisi, notamment comme indiqué avec le dispenseur 21 dans la cavité de dispenseur 12.

Si des moyens de diffraction 17 et 18, sont nécessaires et prévus, ils sont élaborés, comme il est illustré par les schémas successifs de la figure 9B, illustrant les étapes successives du procédé à cet égard. Dans cette réalisation, on dispose d'une plaquette - ou wafer - en verre 8 et on forme sur elle les moyens de diffraction 17 et 18.

Et, comme il est illustré par les schémas successifs de la figure 9C, on assemble et on solidarise de façon fixe la plaquette - ou wafer - en verre pourvue des moyens de diffraction 17 et 18, à et au droit de la plaquette - ou wafer - en verre qui ferme la cellule 2 et inclus les masques 19.

Selon une réalisation particulière, on dispose d'une plaquette - ou wafer - 7 de silicium, gravable, et, comme illustré par la figure 5, on la grave avec une forme pyramidale selon les plans cristallins [111] à 54,7° par gravure humide de sorte à former le réflecteur amont 14, le réflecteur aval 15 et le creux 11a de la cavité optique 11. D'autre part, on associe à la plaquette - ou wafer - en verre 8 les moyens de déviation/diffraction 17 et 18.

Dans le cas où il est prévu que la cellule 2 comporte une cavité de dispenseur 12, le procédé est tel, comme il est représenté sur la figure 9A, que l'on forme ladite cavité de dispenseur 12, de façon adjacente à la cavité optique 11, on réalise également le dégagement qui va permettre la communication 13 entre les deux cavités 11 et 12, on place le dispenseur 21 dans le creux 12a de la cavité de dispenseur 12. Puis, une fois que la plaquette - ou wafer - conformée en creux 7 et la plaquette - ou wafer - en verre 8 sont scellées l'une à l'autre, on assure un chauffage tel qu'est générée de la vapeur alcaline qui migre vers et dans la cavité optique 11 par la communication 13 entre les deux cavités 11 et 12.

Le procédé peut également comprendre une opération d'association à la cellule 2 de moyens optiques de mise en forme du faisceau laser extérieur entrant 5a, en particulier une lame quart d'onde 22 et une lentille de collimation 23.

## Revendications

1. Cellule à vapeur alcaline (2), destinée notamment à être incluse dans une horloge atomique (1), apte à être associée, d'une part, à un laser (3) d'émission d'un faisceau laser extérieur entrant (5a) impactant la cellule (2) et, d'autre part, à un photodétecteur (4) de réception d'un faisceau laser extérieur sortant (5e) de la cellule (2), le faisceau laser (5) ayant traversé la cellule (2), ladite cellule (2) comprenant,
- d'une part, un boîtier (6) ayant une fenêtre optique amont (9) et une fenêtre optique aval (10) et formant une cavité optique (11) emplie de vapeur alcaline telle que comprenant du césium, la fenêtre optique amont (9) et la fenêtre optique aval (10) étant disposées d'un seul et même côté de la cellule (2) et,
- d'autre part, des moyens micro-optiques disposés dans la cavité optique (11) et comprenant un réflecteur optique amont (14) et un réflecteur optique aval (15) du faisceau laser (5), inclinés l'un par rapport à l'autre, le réflecteur amont (14) étant incliné par rapport au plan (P) de la fenêtre amont (9) et à l'axe du faisceau laser (5) entrant, de sorte que le faisceau laser extérieur entrant (5a) traverse la fenêtre amont (9) pour former un faisceau laser intérieur entrant (5b), que le faisceau laser intérieur entrant (5b) soit réfléchi sur le réflecteur amont (14) et dévié en direction du réflecteur aval (15) pour former un faisceau laser intérieur intermédiaire (5c), que le faisceau laser intérieur intermédiaire (5c) soit réfléchi sur le réflecteur aval (15) et dévié en direction de la fenêtre aval (10) pour former un faisceau laser intérieur sortant (5d), et que le faisceau laser (5) intérieur sortant (5d) traverse la fenêtre aval (10) pour former le faisceau laser extérieur sortant (5e), **caractérisée en ce que**
- ladite cellule (2) comprend également des moyens de diffraction amont (17) du faisceau laser extérieur entrant (5a), situés en amont du réflecteur amont (14) et des moyens de diffraction aval (18) du faisceau laser réfléchi (5d) par le réflecteur aval (15), situés en aval du réflecteur aval (15), de sorte à combiner la déviation réalisée par les moyens de diffraction (17, 18) avec la déviation réalisée par le réflecteur associé (14, 15), lesdits moyens de diffraction amont et aval étant respectivement associés aux fenêtres amont et aval,
les réflecteurs (14, 15) et les moyens de diffraction (17, 18) étant configurés de manière à garder l'état de polarisation circulaire du faisceau laser (5) au cours de son trajet,
le faisceau laser extérieur entrant (5a) et le faisceau laser extérieur sortant (5e) étant disposés parallèlement l'un à l'autre, les moyens de diffraction amont et aval et les réflecteurs amonts et aval étant agencés de sorte que le faisceau laser intérieur intermédiaire (5c) forme un angle de 90° avec le faisceau laser extérieur entrant (5a) et avec le faisceau laser extérieur sortant (5e).

2. Cellule à vapeur alcaline (2) selon la revendication 1, dans laquelle le réflecteur amont (14) et le réflecteur aval (15) sont disposés de façon symétrique par rapport à un plan médian transversal de la cellule (2).

3. Cellule à vapeur alcaline (2) selon l'une quelconque des revendications 1 à 3, dans laquelle le réflecteur amont (14) et le réflecteur aval (15) sont écartés l'un de l'autre, l'écartement (16) entre eux conditionnant la dimension de la cavité optique (11) et de la cellule (2) dans la direction (D) de l'axe (FLII) du faisceau laser intérieur intermédiaire (5c).

4. Cellule à vapeur alcaline (2) selon la revendication 3, dans laquelle l'écartement (16) entre le réflecteur amont (14) et le réflecteur aval (15) est compris entre de l'ordre de 3 mm et de l'ordre de 9 mm, plus spécialement entre de l'ordre de 4 mm et de l'ordre de 8 mm, plus spécialement encore entre de l'ordre de 5 mm et de l'ordre de 7 mm.

5. Cellule à vapeur alcaline (2) selon l'une quelconque des revendications 1 à 4, dans laquelle la fenêtre optique amont (9) et la fenêtre optique aval (10) sont formées par deux portions écartées l'une de l'autre d'une seule et même plaquette - ou wafer - en verre (8).

6. Cellule à vapeur alcaline (2) selon l'une quelconque des revendications 1 à 5, qui comprend un seul et même côté d'association avec le laser (3) d'émission du faisceau laser entrant (5a) et avec le photodétecteur (4) de réception du faisceau laser sortant (5e).

7. Cellule à vapeur alcaline (2) selon l'une quelconque des revendications 1 à 6, qui comporte, en outre, dans la cavité optique (11), un ou des masques (19) empêchant le passage du faisceau laser (5) dans la ou les régions non souhaitées.

8. Cellule à vapeur alcaline (2) selon l'une quelconque des revendications 1 à 7, dans laquelle le réflecteur amont (14) et le réflecteur aval (15) sont formés par conformation, en particulier gravure, d'une plaquette - ou wafer - (7), et comportent un revêtement de réflexion (20), en particulier métallique, plus spécialement en aluminium.

9. Cellule à vapeur alcaline (2) selon l'une quelconque des revendications 1 à 8, qui comprend, outre la cavité optique (11), une cavité de dispenseur (12), adjacente à et en communication avec la cavité optique (11), apte à recevoir un dispenseur (21) de métal alcalin, tel que le césium, la vapeur alcaline qui est générée par chauffage après scellement étanche de la cellule (2) migrant vers et dans la cavité optique (11) par la communication (13) entre les deux cavités 11, 12).

10. Cellule à vapeur alcaline (2) selon l'une quelconque des revendications 1 à 9, dans lequel la cavité optique (11) est emplie de vapeur alcaline et d'un gaz tampon.

11. Cellule à vapeur alcaline (2) selon l'une quelconque des revendications 1 à 10, à laquelle sont associés des moyens optiques de mise en forme du faisceau laser (5) extérieur entrant, en particulier une lame quart d'onde (22) et une lentille de collimation (23).

12. Cellule à vapeur alcaline (2) selon l'une quelconque des revendications 1 à 11, dont le boîtier (6) comprend, d'une part, une plaquette - ou wafer - conformable (7), conformée en creux de sorte à former le creux (11 a) de la cavité optique (11), le réflecteur amont (14), le réflecteur aval (15), le cas échéant le creux (12a) de la cavité de dispenseur (12) et le dégagement (13a) de la communication (13) entre les deux cavités (11, 12) et, d'autre part, une plaquette - ou wafer - en verre (8) de sorte à former la fenêtre optique amont (9) et la fenêtre optique aval (10) et à fermer la cavité optique (11), le cas échéant la cavité de dispenseur(12), et à laquelle sont associés des moyens de diffraction (17, 18)la plaquette - ou wafer - en verre (8) et la plaquette - ou wafer - (7) conformée en creux étant disposées en regard l'une de l'autre et scellées l'une à l'autre, en particulier par soudure anodique.

13. Cellule à vapeur alcaline (2) selon l'une quelconque des revendications 1 à 12, qui comporte une plaquette - ou wafer - conformable (7), gravée en creux de sorte à former le creux de la cavité optique (11), le réflecteur amont (14), le réflecteur aval (15), le cas échéant le creux (12a) de la cavité de dispenseur (12) et le dégagement (13a) de la communication (13) entre les deux cavités (11, 12), le réflecteur amont (14) et le réflecteur aval (15) étant gravés selon les plans cristallins du matériau constitutif de la plaquette - ou wafer - conformable (7).

14. Cellule à vapeur alcaline (2) selon la revendication 13, qui comprend une plaquette - ou wafer - (7) de silicium, conformable, gravée avec une forme pyramidale selon les plans cristallins [111] à 54,7° de sorte à former le réflecteur amont (14), le réflecteur aval (15) et le creux (11 a) de la cavité optique (11) et, en combinaison, des moyens de diffraction amont (17) en direction du bord extérieur adjacent de la cellule (2) et des moyens de diffraction aval (18) avec un angle de 19,48°.

15. Procédé de fabrication d'une cellule à vapeur alcaline (2) selon l'une quelconque des revendications 12 à 14, dans lequel :
- on dispose d'une plaquette - ou wafer - conformable (7) et on la conforme en creux, en particulier on la grave, de sorte à former le creux (11a) de la cavité optique (11), le réflecteur amont (14), le réflecteur aval (15), le cas échéant le creux (12a) de la cavité de dispenseur (12) et le dégagement (13a) de la communication (13) entre les deux cavités (11, 12),
- on dispose d'une plaquette - ou wafer - en verre (8) apte à former la fenêtre optique amont (9) et la fenêtre optique aval (10) et à fermer la cavité optique (11), le cas échéant la cavité de dispenseur (12),
- d'une part, on dispose l'une en regard de l'autre et on scelle l'une à l'autre, en particulier par soudure anodique, la plaquette - ou wafer - conformée en creux (7) et la plaquette - ou wafer - en verre (8),
- d'autre part, on emplit la cavité optique (11) de vapeur alcaline,
- et on associe à la plaquette - ou wafer - en verre (8) des moyens de diffraction (17, 18).

16. Procédé de fabrication d'une cellule à vapeur alcaline (2) selon la revendication 15, dans lequel :
- d'une part, on dispose d'une plaquette - ou wafer - (7) de silicium, gravable, et on la grave avec une forme pyramidale selon les plans cristallins [111] à 54,7° par gravure humide de sorte à former le réflecteur amont (14), le réflecteur aval (15) et le creux de la cavité optique (11),
- d'autre part, on associe à la plaquette - ou wafer - en verre (8) des moyens de diffraction (17, 18).

17. Procédé de fabrication d'une cellule à vapeur alcaline (2) selon l'une quelconque des revendications 15 et 16, dans lequel on forme une cavité de dispenseur (12), adjacente à et en communication avec la cavité optique (11), on place un dispenseur (21) de métal alcalin, tel que le césium, dans la cavité de dispenseur (12) et, une fois que la plaquette - ou wafer - conformée en creux (7) et la plaquette - ou wafer - en verre (8) sont scellées l'une à l'autre, on assure un chauffage tel qu'est générée de la vapeur alcaline qui migre vers et dans la cavité optique (11) par la communication (13) entre les deux cavités (11, 12).

18. Procédé de fabrication d'une cellule à vapeur alcaline (2) selon l'une quelconque des revendications 15 à 17, qui comprend l'une au moins des opérations suivantes :
- mise en place d'un ou plusieurs masques (19) dans la cavité optique (11) en vue d'empêcher le passage du faisceau laser (5) dans la ou les régions non souhaitées,
- mise en place sur le réflecteur amont (14) et le réflecteur aval (15) d'un revêtement de réflexion (20), en particulier métallique, plus spécialement en aluminium,
- introduction dans la cavité optique (11) d'un gaz tampon,
- association à la cellule à vapeur alcaline (2) de moyens optiques de mise en forme du faisceau laser (5) extérieur entrant, en particulier une lame quart d'onde (22) et une lentille de collimation (23).

19. Horloge atomique (1) comprenant une cellule à vapeur alcaline (2) selon l'une quelconque des revendications 1 à 14, associée, de façon compacte, d'une part, à un laser (3) d'émission d'un faisceau laser extérieur entrant (5a) impactant la cellule (2) et, d'autre part, à un photodétecteur (4) de réception d'un faisceau laser extérieur sortant (5e) de la cellule (2).

20. Horloge atomique (1) selon la revendication 19, dans laquelle le laser (3) d'émission du faisceau laser entrant (5a) et le photodétecteur (4) de réception du faisceau laser sortant (5e) sont associés à la cellule (2) sur un seul et même côté d'association de celle-ci.

21. Horloge atomique (1) selon l'une quelconque des revendications 19 et 20, dans laquelle le faisceau laser entrant (5a) et le faisceau laser sortant (5e) sont disposés parallèlement l'un à l'autre, l'un à côté de l'autre.

22. Horloge atomique (1) selon l'une quelconque des revendications 19 à 21, dans laquelle le laser (3) est un laser à cavité verticale VCSEL.

## Patentansprüche

1. Alkalidampfzelle (2), die insbesondere zum Einschließen in eine Atomuhr (1) bestimmt ist und die einerseits mit einem Laser (3) zum Emittieren eines ankommenden äußeren Laserstrahls (5a), der auf eine Zelle (2) auftritt, und andererseits mit einem Photodetektor (4) zum Empfangen eines abgehenden äußeren Laserstrahls (5e) von der Zelle (2) assoziiert werden kann, wobei der Laserstrahl (5) die Zelle (2) durchquert hat, wobei die Zelle (2) Folgendes umfasst:
- einerseits ein Gehäuse (6) mit einem stromaufwärts gelegenen optischen Fenster (9) und einem stromabwärts gelegenen optischen Fenster (10), das einen optischen Hohlraum (11) bildet, der mit Alkalidampf gefüllt ist, der beispielsweise Cäsium enthält, wobei das stromaufwärts gelegene optische Fenster (9) und das stromabwärts gelegene optische Fenster (10) auf ein und derselben Seite der Zelle (2) angeordnet sind, und
- andererseits mikrooptische Mittel, die in dem optischen Hohlraum (11) angeordnet sind und einen stromaufwärts gelegenen optischen Reflektor (14) und einen stromabwärts gelegenen optischen Reflektor (15) für den Laserstrahl (5) umfassen, die in Bezug zueinander geneigt sind, wobei der stromaufwärts gelegene Reflektor (14) in Bezug auf die Ebene (P) des stromaufwärts gelegenen Fensters (9) und die Achse des ankommenden Laserstrahls (5) geneigt ist, so dass der ankommende äußere Laserstrahl (5a) das stromaufwärts gelegene Fenster (9) durchdringt, um einen ankommenden inneren Laserstrahl (5b) zu bilden, so dass der ankommende innere Laserstrahl (5b) auf den stromaufwärts gelegenen Reflektor (14) reflektiert und zum stromabwärts gelegenen Reflektor (15) abgelenkt wird, um einen inneren Zwischenlaserstrahl (5c) zu bilden, so dass der innere Zwischenlaserstrahl (5c) auf den stromabwärts gelegenen Reflektor (15) reflektiert und in Richtung des stromabwärts gelegenen Fensters (10) abgelenkt wird, um einen abgehenden inneren Laserstrahl (5d) zu bilden, und so dass der abgehende innere Laserstrahl (5d) das stromabwärts gelegene Fenster (10) durchdringt, um den abgehenden äußeren Laserstrahl (5e) zu bilden, **dadurch gekennzeichnet, dass**
- die Zelle (2) auch stromaufwärts gelegene Beugungsmittel (17) für den ankommenden äußeren Laserstrahl (5a), die sich stromaufwärts des stromaufwärts gelegenen Reflektors (14) befinden, und stromabwärts gelegene Beugungsmittel (18) für den vom stromabwärts gelegenen Reflektor (15) reflektierten Laserstrahl (5d) umfasst, die stromabwärts des stromabwärts gelegenen Reflektors (15) angeordnet sind, um die von den Beugungsmitteln (17, 18) erzeugte Ablenkung mit der von dem assoziierten Reflektor (14, 15) erzeugten Ablenkung zu kombinieren, wobei die stromaufwärts und stromabwärts gelegenen Beugungsmittel mit dem stromaufwärts beziehungsweise stromabwärts gelegenen Fenster assoziiert sind,
wobei die Reflektoren (14, 15) und die Beugungsmittel (17, 18) zum Halten des zirkularen Polarisationszustands des Laserstrahls (5) auf seinem Weg konfiguriert sind,
wobei der ankommende äußere Laserstrahl (5a) und der abgehende äußere Laserstrahl (5e) parallel zueinander angeordnet sind, wobei die stromaufwärts und stromabwärts gelegenen Beugungsmittel und die stromaufwärts und stromabwärts gelegenen Reflektoren so angeordnet sind, dass der innere Zwischenlaserstrahl (5c) einen Winkel von 90° mit dem ankommenden äußeren Laserstrahl (5a) und mit dem abgehenden äußeren Laserstrahl (5e) bildet.

2. Alkalidampfzelle (2) nach Anspruch 1, wobei der stromaufwärts gelegene Reflektor (14) und der stromabwärts gelegene Reflektor (15) symmetrisch in Bezug auf eine transversale Mittelebene der Zelle (2) angeordnet sind.

3. Alkalidampfzelle (2) nach einem der Ansprüche 1 bis 3, wobei der stromaufwärts gelegene Reflektor (14) und der stromabwärts gelegene Reflektor (15) voneinander beabstandet sind, wobei der Abstand (16) zwischen ihnen die Abmessung des optischen Hohlraums (11) und der Zelle (2) in Richtung (D) der Achse (FLII) des inneren Zwischenlaserstrahls (5c) bestimmt.

4. Alkalidampfzelle (2) nach Anspruch 3, wobei der Abstand (16) zwischen dem stromaufwärts gelegenen Reflektor (14) und dem stromabwärts gelegenen Reflektor (15) zwischen etwa 3 mm und etwa 9 mm, spezieller zwischen etwa 4 mm und etwa 8 mm, noch spezieller zwischen etwa 5 mm und etwa 7 mm liegt.

5. Alkalidampfzelle (2) nach einem der Ansprüche 1 bis 4, wobei das stromaufwärts gelegene optische Fenster (9) und das stromabwärts gelegene optische Fenster (10) durch zwei voneinander beabstandete Abschnitte einer/s einzigen Glasscheibe oder -wafers (8) gebildet sind.

6. Alkalidampfzelle (2) nach einem der Ansprüche 1 bis 5, die ein und dieselbe Seite zur Assoziation mit dem Laser (3) zum Emittieren des ankommenden Laserstrahls (5a) und mit dem Photodetektor (4) zum Empfangen des abgehenden Laserstrahls (5e) umfasst.

7. Alkalidampfzelle (2) nach einem der Ansprüche 1 bis 6, die ferner im optischen Hohlraum (11) eine oder mehrere Masken (19) umfasst, die den Durchgang des Laserstrahls (5) in die oder mehreren unerwünschten Bereiche verhindern.

8. Alkalidampfzelle (2) nach einem der Ansprüche 1 bis 7, wobei der stromaufwärts gelegene Reflektor (14) und der stromabwärts gelegene Reflektor (15) durch Formanpassung, insbesondere Ätzen, einer/s Scheibe oder Wafers (7) gebildet sind und eine reflektierende Beschichtung (20), insbesondere aus Metall, spezieller aus Aluminium, umfassen.

9. Alkalidampfzelle (2) nach einem der Ansprüche 1 bis 8, die zusätzlich zu dem optischen Hohlraum (11) einen Spenderhohlraum (12) neben und in Verbindung mit dem optischen Hohlraum (11) umfasst, der zum Aufnehmen eines Spenders (21) aus Alkalimetall wie Cäsium geeignet ist, wobei der durch Erhitzen nach dem Abdichten der Zelle (2) erzeugte Alkalidampf durch die Verbindung (13) zwischen den beiden Hohlräumen (11, 12) in Richtung auf und in den optischen Hohlraum (11) wandert.

10. Alkalidampfzelle (2) nach einem der Ansprüche 1 bis 9, wobei der optische Hohlraum (11) mit Alkalidampf und einem Puffergas gefüllt ist.

11. Alkalidampfzelle (2) nach einem der Ansprüche 1 bis 10, mit der optische Mittel zum Formen des ankommenden äußeren Laserstrahls (5), insbesondere eine Viertelwellenplatte (22) und eine Kollimationslinse (23), assoziiert sind.

12. Alkalidampfzelle (2) nach einem der Ansprüche 1 bis 11, deren Gehäuse (6) einerseits eine(n) anpassungsfähige(n) Scheibe oder Wafer (7), hohl ausgebildet zum Bilden der Höhlung (11a) des optischen Hohlraums (11), den stromaufwärts gelegenen Reflektor (14), den stromabwärts gelegenen Reflektor (15), gegebenenfalls die Höhlung (12a) des Spenderhohlraums (12) und den Freiraum (13a) der Verbindung (13) zwischen den beiden Hohlräumen (11, 12), und andererseits eine(n) Glasscheibe oder -wafer (8) zum Bilden des stromaufwärts gelegenen optischen Fensters (9) und des stromabwärts gelegenen optischen Fensters (10) und zum Schließen des optischen Hohlraums (11), gegebenenfalls des Spenderhohlraums (12), umfasst, und mit dem Beugungsmittel (17, 18) assoziiert sind, wobei die/der Glasscheibe oder -wafer (8) und die/der hohl ausgebildete Glasscheibe oder -wafer (7) einander gegenüberliegend angeordnet und gegeneinander abgedichtet sind, insbesondere durch anodisches Schweißen.

13. Alkalidampfzelle (2) nach einem der Ansprüche 1 bis 12, die eine(n) anpassungsfähige(n) Scheibe oder Wafer (7), die hohl eingeätztt ist, zum Bilden der Höhlung des optischen Hohlraums (11), den stromaufwärts gelegenen Reflektor (14), den stromabwärts gelegenen Reflektor (15), gegebenenfalls die Höhlung (12a) des Spenderhohlraums (12) und den Freiraum (13a) der Verbindung (13) zwischen den beiden Hohlräumen (11, 12) umfasst, wobei der stromaufwärts gelegene Reflektor (14) und der stromabwärts gelegene Reflektor (15) gemäß den Kristallebenen des die/den anpassungsfähige(n) Scheibe oder Wafer (7) bildenden Materials graviert sind.

14. Alkalidampfzelle (2) nach Anspruch 13, die eine(n) anpassungsfähige(n) Siliciumscheibe oder -wafer (7), die/der gemäß den Kristallebenen [111] pyramidenförmig auf 54,7° zum Bilden des stromaufwärts gelegenen Reflektors (14), des stromabwärts gelegenen Reflektors (15) und der Höhlung (11a) des optischen Hohlraums (11) geätzt ist, sowie in Kombination stromabwärts gelegene Beugungsmittel (18) in Richtung des angrenzenden äußeren Randes der Zelle (2) und stromaufwärts gelegene Beugungsmittel (17) mit einem Winkel von 19,48° umfasst.

15. Verfahren zur Herstellung einer Alkalidampfzelle (2) nach einem der Ansprüche 12 bis 14, wobei:
- ein(e) anpassungsfähige(n) Scheibe oder Wafer (7) vorgesehen und hohl ausgebildet wird, insbesondere die geätzt wird, um die Höhlung (11a) des optischen Hohlraums (11), den stromaufwärts gelegenen Reflektor (14), den stromabwärts gelegenen Reflektor (15), gegebenenfalls die Höhlung (12a) des Spenderhohlraums (12) und den Freiraum (13a) der Verbindung (13) zwischen den beiden Hohlräumen (11, 12) zu bilden,
- ein(e) Glasscheibe oder -wafer (8) vorgesehen ist, die/das das stromaufwärts gelegene optische Fenster (9) und das stromabwärts gelegene optische Fenster (10) bilden und den optischen Hohlraum (11), gegebenenfalls den Spenderhohlraum (12), verschließen kann,
- einerseits die/der hohl ausgebildete Scheibe oder Wafer (7) und die/der Glasscheibe oder -wafer (8) gegenüberliegend angeordnet und gegeneinander abgedichtet werden, insbesondere durch anodisches Schweißen,
- andererseits der optische Hohlraum (11) mit Alkalidampf gefüllt wird,
- und Beugungsmittel (17, 18) mit der/dem Glasscheibe oder -wafer (8) assoziiert werden.

16. Verfahren zur Herstellung einer Alkalidampfzelle (2) nach Anspruch 15, wobei:
- einerseits ein(e) ätzbare(r) Siliciumscheibe oder -wafer (7) bereitgestellt und durch Nassätzen gemäß den Kristallebenen [111] pyramidenförmig auf 54,7° geätzt wird, um den stromaufwärts gelegenen Reflektor (14), den stromabwärts gelegenen Reflektor (15) und die Höhlung des optischen Hohlraums (11) zu bilden,
- andererseits Beugungsmittel (17, 18) mit der/dem Glasscheibe oder -wafer (8) assoziiert werden.

17. Verfahren zur Herstellung einer Alkalidampfzelle (2) nach einem der Ansprüche 15 und 16, wobei ein Spenderhohlraum (12) angrenzend an den optischen Hohlraum (11) und in Verbindung damit gebildet wird, ein Spender (21) von Alkalimetall, wie z.B. Cäsium, im Spenderhohlraum (12) platziert wird und nach dem Abdichten der/des ausgehöhlten Scheibe oder Wafers (8) und der/des Glasscheibe oder -wafers (8) gegeneinander eine solche Erhitzung erfolgt, dass Alkalidampf erzeugt wird, der durch die Verbindung (13) zwischen den beiden Hohlräumen (11, 12) zu dem und in den optischen Hohlraum (11) wandert.

18. Verfahren zur Herstellung einer Alkalidampfzelle (2) nach einem der Ansprüche 15 bis 17, das mindestens einen der folgenden Schritte umfasst:
- Aufbringen einer oder mehrerer Masken (19) in dem optischen Hohlraum (11), um den Durchgang des Laserstrahls (5) in die eine oder mehreren unerwünschten Zonen zu verhindern,
- Aufbringen einer Reflexionsbeschichtung (20), insbesondere aus Metall, spezieller aus Aluminium, auf den stromaufwärts gelegenen Reflektor (14) und den stromabwärts gelegenen Reflektor (15),
- Einleiten eines Puffergases in den optischen Hohlraum (11),
- Assoziieren von optischen Mitteln mit der Alkalidampfzelle (2) zur Formung des ankommenden äußeren Laserstrahls (5), insbesondere einer Viertelwellenplatte (22) und einer Kollimationslinse (23).

19. Atomuhr (1) umfassend eine Alkalidampfzelle (2) nach einem der Ansprüche 1 bis 14, die in kompakter Weise einerseits mit einem Laser (3) zum Emittieren eines ankommenden äußeren Laserstrahls (5a), der auf die Zelle (2) auftrifft, und andererseits mit einem Photodetektor (4) zum Empfangen eines von der Zelle (2) abgehenden äußeren Laserstrahls (5e) assoziiert ist.

20. Atomuhr (1) nach Anspruch 19, wobei der Laser (3) zum Emittieren des ankommenden Laserstrahls (5a) und der Photodetektor (4) zum Empfangen des abgehenden Laserstrahls (5e) auf ein und derselben Assoziationsseite der Zelle (2) mit der Zelle (2) assoziiert sind.

21. Atomuhr (1) nach einem der Ansprüche 19 und 20, wobei der ankommende Laserstrahl (5a) und der abgehende Laserstrahl (5e) parallel zueinander und nebeneinander angeordnet sind.

22. Atomuhr (1) nach einem der Ansprüche 19 bis 21, wobei der Laser (3) ein Laser mit vertikalem Hohlraum (VCSEL) ist.

## Claims

1. An alkali-metal vapor cell (2), particularly intended to be included in an atomic clock (1), capable of being connected, on the one hand, to a laser (3) for emitting an incoming external laser beam (5a) striking the cell (2) and, on the other hand, to a photodetector (4) for receiving an outgoing external laser beam (5e) from the cell (2), with the laser beam (5) having passed through the cell (2), said cell (2) comprising,
- on the one hand, a casing (6) having an upstream optical window (9) and a downstream optical window (10) and forming an optical cavity (11) filled with alkali-metal vapor such as vapor containing cesium, the upstream optical window (9) and the downstream optical window (10) being disposed on the same side of the cell (2); and
- on the other hand, micro-optical means disposed in the optical cavity (11) and comprising an upstream optical reflector (14) and a downstream optical reflector (15) for the laser beam (5), said reflectors being inclined relative to one another, the upstream reflector (14) being inclined relative to the plane (P) of the upstream window (9) and to the axis of the incoming laser beam (5), such that the incoming external laser beam (5a) passes through the upstream window (9) to form an incoming internal laser beam (5b), such that the incoming internal laser beam (5b) is reflected onto the upstream reflector (14) and deviated towards the downstream reflector (15) to form an intermediate internal laser beam (5c), such that the intermediate internal laser beam (5c) is reflected onto the downstream reflector (15) and deviated towards the downstream window (10) to form an outgoing internal laser beam (5d), and such that the outgoing internal laser beam (5d) passes through the downstream window (10) to form the outgoing external laser beam (5e), **characterised in that**:
- said cell (2) also comprises upstream diffraction means (17) for the incoming external laser beam (5a), located upstream of the upstream reflector (14), and downstream diffraction means (18) for the laser beam (5d) reflected by the downstream reflector (15), located downstream of the downstream reflector (15), so as to combine the deviation produced by the diffraction means (17, 18) with the deviation produced by the associated reflector (14, 15), with said upstream and downstream diffraction means being respectively connected to the upstream and downstream windows,
the reflectors (14, 15) and the diffraction means (17, 18) being configured so as to maintain the circular polarisation state of the laser beam (5) on its path,
the incoming external laser beam (5a) and the outgoing external laser beam (5e) being disposed parallel to each other, the upstream and downstream diffraction means and the upstream and downstream reflectors being arranged so that the intermediate internal laser beam (5c) forms a 90° angle with the incoming external laser beam (5a) and with the outgoing external laser beam (5e).

2. The alkali-metal vapor cell (2) according to claim 1, wherein the upstream reflector (14) and the downstream reflector (15) are symmetrically disposed relative to a transverse median plane of the cell (2).

3. The alkali-metal vapor cell (2) according to any one of claims 1 to 3, wherein the upstream reflector (14) and the downstream reflector (15) are spaced apart from each other, with the spacing (16) between them determining the dimension of the optical cavity (11) and of the cell (2) in the direction (D) of the axis (FLII) of the intermediate internal laser beam (5c).

4. The alkali-metal vapor cell (2) according to claim 3, wherein the spacing (16) between the upstream reflector (14) and the downstream reflector (15) ranges between approximately 3 mm and approximately 9 mm, more specifically between approximately 4 mm and approximately 8 mm, even more specifically between approximately 5 mm and approximately 7 mm.

5. The alkali-metal vapor cell (2) according to any one of claims 1 to 4, wherein the upstream optical window (9) and the downstream optical window (10) are formed by two portions, spaced apart from each other, of the same glass plate or wafer (8).

6. The alkali-metal vapor cell (2) according to any one of claims 1 to 5, comprising the same side for connecting to the laser (3) emitting the incoming laser beam (5a) and to the photodetector (4) for receiving the outgoing laser beam (5e).

7. The alkali-metal vapor cell (2) according to any one of claims 1 to 6, further comprising, in the optical cavity (11), one or more masks (19) preventing the passage of the laser beam (5) into the one or more unwanted areas.

8. The alkali-metal vapor cell (2) according to any one of claims 1 to 7, wherein the upstream reflector (14) and the downstream reflector (15) are formed by shaping, in particular by etching, a plate or wafer (7), and they comprise a reflective coating (20), in particular of metal, more specifically of aluminium.

9. The alkali-metal vapor cell (2) according to any one of claims 1 to 8, comprising, in addition to the optical cavity (11), a dispenser cavity (12), adjacent to and connected to the optical cavity (11), capable of accommodating a dispenser (21) of alkali metal such as cesium, with the alkali-metal vapor that is generated by heating after sealing the cell (2) migrating towards and into the optical cavity (11) through the connection (13) between the two cavities (11, 12).

10. The alkali-metal vapor cell (2) according to any one of claims 1 to 9, wherein the optical cavity (11) is filled with alkali-metal vapor and a buffer gas.

11. The alkali-metal vapor cell (2) according to any one of claims 1 to 10, to which optical means are connected for shaping the incoming external laser beam (5), in particular a quarter-wave strip (22) and a collimating lens (23).

12. The alkali-metal vapor cell (2) according to any one of claims 1 to 11, the casing (6) of which comprises, on the one hand, a shapeable plate or wafer (7), shaped as a recess so as to form the recess (11a) of the optical cavity (11), the upstream reflector (14), the downstream reflector (15), if applicable the recess (12a) of the dispenser cavity (12) and the clearance (13a) of the connection (13) between the two cavities (11, 12), and on the other hand, a glass plate or wafer (8) so as to form the upstream optical window (9) and the downstream optical window (10) and to close the optical cavity (11), if applicable the dispenser cavity (12), and to which diffraction means (17, 18) are connected, the glass plate or wafer (8) and the recess-shaped plate or wafer (7) being disposed opposite each other and being sealed together, in particular by anodic bonding.

13. The alkali-metal vapor cell (2) according to any one of claims 1 to 12, comprising a shapeable plate or wafer (7), etched as a recess so as to form the recess of the optical cavity (11), the upstream reflector (14), the downstream reflector (15), if applicable the recess (12a) of the dispenser cavity (12) and the clearance (13a) of the connection (13) between the two cavities (11, 12), the upstream reflector (14) and the downstream reflector (15) being etched along the crystal planes of the constituent material of the shapeable plate or wafer (7).

14. The alkali-metal vapor cell (2) according to claim 13, comprising a shapeable silicon plate or wafer (7), etched with a pyramid shape along the crystal planes [111] at 54.7° so as to form the upstream reflector (14), the downstream reflector (15) and the recess (11a) of the optical cavity (11) and, in combination, upstream diffraction means (17) towards the adjacent external edge of the cell (2) and downstream diffraction means (18) with an angle of 19.48°.

15. A method for manufacturing an alkali-metal vapor cell (2) according to any one of claims 12 to 14, wherein:
- a shapeable plate or wafer (7) is provided and is shaped as a recess, in particular it is etched, so as to form the recess (11a) of the optical cavity (11), the upstream reflector (14), the downstream reflector (15), if applicable the recess (12a) of the dispenser cavity (12) and the clearance (13a) of the connection (13) between the two cavities (11, 12);
- a glass plate or wafer (8) is provided that is capable of forming the upstream optical window (9) and the downstream optical window (10) and of closing the optical cavity (11), if applicable the dispenser cavity (12);
- on the one hand, the recess-shaped plate or wafer (7) and the glass plate or wafer (8) are placed opposite each other and they are sealed together, in particular by anodic bonding;
- on the other hand, the optical cavity (11) is filled with alkali-metal vapor; and
- the glass plate or wafer (8) is connected to diffraction means (17, 18).

16. The method for manufacturing an alkali-metal vapor cell (2) according to claim 15, wherein:
- on the one hand, an etchable silicon plate or wafer (7) is provided and is etched with a pyramid shape along the crystal planes [111] at 54.7° by wet etching so as to form the upstream reflector (14), the downstream reflector (15) and the recess of the optical cavity (11);
- on the other hand, the glass plate or wafer (8) is connected to diffraction means (17, 18).

17. The method for manufacturing an alkali-metal vapor cell (2) according to any one of claims 15 and 16, wherein a dispenser cavity (12) is formed, adjacent to and connected to the optical cavity (11), a dispenser (21) of alkali metal, such as cesium, is placed in the dispenser cavity (12), and once the recess-shaped plate or wafer (7) and the glass plate or wafer (8) are sealed together, heating is implemented such that alkali-metal vapor that migrates towards and into the optical cavity (11) via the connection (13) between the two cavities (11, 12) is generated.

18. The method for manufacturing an alkali-metal vapor cell (2) according to any one of claims 15 to 17, comprising at least one of the following operations:
- placing one or more masks (19) in the optical cavity (11) in order to prevent the laser beam (5) from passing into the one or more unwanted area(s);
- placing a reflective coating (20), in particular of metal, more specifically of aluminium, onto the upstream reflector (14) and the downstream reflector (15);
- introducing a buffer gas into the optical cavity (11);
- connecting the alkali-metal vapor cell (2) to optical means for shaping the incoming external laser beam (5), in particular a quarter-wave strip (22) and a collimating lens (23).

19. An atomic clock comprising an alkali-metal vapor cell (2) according to any one of claims 1 to 14, compactly connected, on the one hand, to a laser (3) for emitting an incoming external laser beam (5a) striking the cell (2) and, on the other hand, to a photodetector (4) for receiving an outgoing external laser beam (5e) from the cell (2).

20. The atomic clock (1) according to claim 19, wherein the laser (3) for emitting the incoming laser beam (5a) and the photodetector (4) for receiving the outgoing laser beam (5e) are connected to the cell (2) on one and the same side for connecting said cell.

21. The atomic clock (1) according to any one of claims 19 and 20, wherein the incoming laser beam (5a) and the outgoing laser beam (5e) are disposed parallel to each other, next to each other.

22. The atomic clock (1) according to any one of claims 19 to 21, wherein the laser (3) is a vertical cavity laser, VCSEL.
